# Europäisches Patentamt
# European Patent Office
# Office européen des brevets

(19)

(11) Numéro de publication: **0 127 488**
**B1**

(12) # FASCICULE DE BREVET EUROPEEN

(45) Date de publication du fascicule du brevet:
**17.11.88**

(51) Int. Cl.⁴: **H 01 L 29/08, H 01 L 29/36**

(21) Numéro de dépôt: **84400562.9**

(22) Date de dépôt: **20.03.84**

(54) Procédé de fabrication d'un transistor de puissance à tenue en tension élevée à l'ouverture.

(30) Priorité: **31.03.83 FR 8305359**

(43) Date de publication de la demande:
**05.12.84 Bulletin 84/49**

(45) Mention de la délivrance du brevet:
**17.11.88 Bulletin 88/46**

(84) Etats contractants désignés:
**DE FR GB IT NL**

(56) Documents cités:
**FR - A - 2 200 625**

**IBM TECHNICAL DISCLOSURE BULLETIN, vol. 22, no.
12, mai 1980, pages 5556-5557, New York, US; G. DAS et
al.: "High performance bipolar transistor with low Cc"
IBM TECHNICAL DISCLOSURE BULLETIN, vol. 19, no. 8,
janvier 1977, pages 3100-3101, New York, US; C.G.
JAMBOTKAR et al.: "Multicollector high-voltage power
transistor design"**

(73) Titulaire: **THOMSON-CSF, 173, Boulevard Haussmann,
F-75379 Paris Cédex 08 (FR)**

(72) Inventeur: **Bouard, Philippe, THOMSON-CSF
SCPI 173 bld Haussmann, F-75379 Paris Cedex 08 (FR)**

(74) Mandataire: **Rinuy, Santarelli, 14, avenue de la Grande
Armée, F-75017 Paris (FR)**

## Description

La présente invention concerne le domaine des transistors de puissance pouvant supporter des tensions élevées, c'est-à-dire par exemple de l'ordre de 500 à 1500 volts et concerne plus particulièrement de tels transistors appelés à fonctionner en régime de commutation, c'est-à-dire par passage brutal de l'état de conduction à l'état de blocage et inversement.

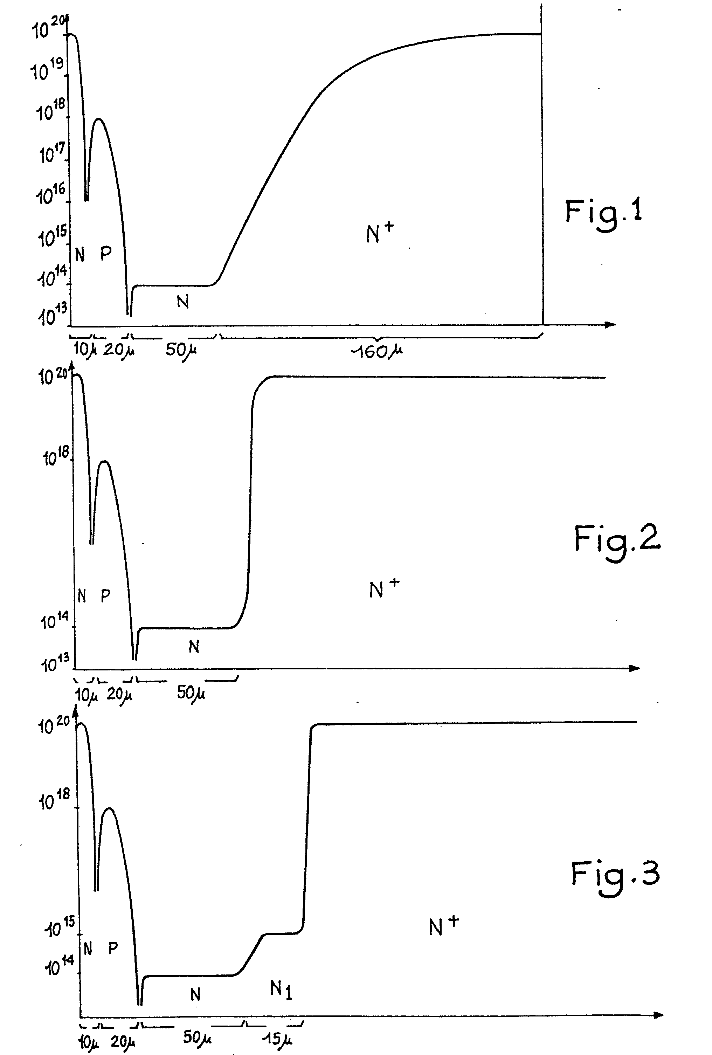

Les figures 1 à 3 caractérisent divers types de transistors de puissance classiques et représentent en ordonnées le niveau de dopage dans les diverses couches du transistor et en abscisses l'épaisseur du transistor.

La figure 1 représente une structure de transistor du type dit triple diffusé. En partant de l'électrode de collecteur, on trouve successivement une zone de type $N^+$ de contact de collecteur obtenue par diffusion, une zone de type N de collecteur correspondant au substrat initial, une zone de type P de base diffusée dans le substrat et une zone de type N d'émetteur. Des ordres de grandeur de dopage et d'épaisseur des diverses couches apparaissent sur la figure et correspondent sensiblement à un transistor pour lequel la tension de claquage collecteur/base en base ouverte est de l'ordre de 1000 volts.

Pour fabriquer un transistor triple diffusé du type représenté en figure 1, on part d'un substrat de type N faiblement dopé, dont le dopage correspond à celui que l'on a choisi comme dopage de collecteur, et l'on procède à une diffusion profonde de type $N^+$ à partir des deux faces du substrat (en effet, on ne sait pas ou l'on sait mal masquer une face d'un substrat dans le cas d'une diffusion de type N de longue durée). Après cela, on élimine, généralement par rodage, la zone diffusée d'un côté de la plaquette et l'on procède aux diffusions de base et d'émetteur. Une première limitation de ce procédé de fabrication résulte du fait qu'il n'est pas possible de former économiquement des zones diffusées très profondes. A titre d'exemple, il ne semble pas raisonnable en pratique d'envisager des diffusions de collecteur d'une profondeur supérieure à 250 microns, ne serait-ce qu'en raison des durées de diffusion nécessaires. Ainsi, en pratique, les diffusions de contact de collecteur ont une épaisseur de l'ordre de 100 à 200 microns. Etant donné que les épaisseurs d'émetteur, de base et de collecteur sont bien déterminées en fonction des caractéristiques souhaitées du transistor, par exemple de l'ordre de 80 microns pour l'ensemble dans le cas représenté, on arrive à une épaisseur de plaquette de 180 à 280 microns. Or, une plaquette de cette épaisseur présente une fragilité mécanique certaine et est susceptible d'être brisée au cours de l'opération de rodage ou des manipulations ultérieures. Ainsi, ce procédé est limité aux cas où l'on envisage le traitement de plaquettes ayant un diamètre inférieur à 10 cm. Quand on envisage de traiter des plaquettes de silicium de grande surface, de diamètre supérieur à 10 cm, il faut pouvoir utiliser des plaquettes plus épaisses, par exemple d'une épaisseur de l'ordre de 300 à 500 microns, et la fabrication de dispositifs du type triple diffusé n'est plus envisageable.

Ainsi, quand on veut traiter des plaquettes de grande surface, de diamètre supérieur à 10 cm (4 pouces), on est amené à utiliser des technologies dans lesquelles on part d'un substrat très fortement dopé à partir duquel on forme le collecteur par épitaxie.

La figure 2 représente le type le plus simple de transistor à collecteur épitaxié. On part d'un substrat très fortement dopé de type $N^+$ sur lequel on forme par épitaxie une couche de type N à faible niveau de dopage, par exemple $10^{14}$ atomes/cm$^3$ dans le cas illustré, et l'on forme ensuite par diffusion dans cette couche épitaxiée les zones de base et d'émetteur respectivement de type P, puis de type N. Dans ce cas, l'épaisseur de la couche $N^+$ peut être librement choisie et a notamment une épaisseur suffisante pour présenter une solidité mécanique adaptée à la dimension de la plaquette. Par exemple, on pourra partir d'un substrat dopé de type $N^+$ d'une épaisseur de 300 à 400 microns sur lequel on développe une couche épitaxiée dont l'épaisseur sera de l'ordre de la centaine de microns et dans laquelle on diffusera sur une profondeur d'environ 30 microns la zone de base, puis sur une épaisseur de l'ordre de la dizaine de microns la zone d'émetteur. Bien entendu, les zones de base et d'émetteur peuvent être formées par tous procédés choisis qui ne seront pas détaillés ici car il ne s'agit pas là du sujet essentiel de l'invention. A titre d'exemple, ces couches peuvent être formées par implantation ionique ou même par épitaxie.

La figure 3 indique une variante connue (IBM TDB, Vol 19, N° 8, janv. 1977, P 3100–3101) de transistor épitaxié. La différence avec la figure 2 est qu'au lieu de trouver une couche de collecteur de concentration uniforme, cette couche de collecteur est décomposée en deux couches épitaxiées successives N et N1, la couche N1, du côté du substrat, présentant une concentration en impuretés dopantes plus élevée que celle de la couche de collecteur proprement dite. Les deux épitaxies successives peuvent être formées dans un même bâti d'épitaxie en faisant varier au cours du processus la concentration de dopant. Cette structure présente divers avantages, notamment de tenue en tension à la commutation à l'ouverture, par rapport à la structure de la figure 2. Les explications théoriques actuelles de cette amélioration de la tenue en tension à la commutation à l'ouverture se basent essentiellement sur le fait que, dans le cas de la figure 2, l'interface d'épitaxie entre le substrat $N^+$ et la couche épitaxiée de collecteur de type N est fortement perturbée alors que, dans le cas de la figure 3, cette interface est de bien meilleurs qualité entre les couches de collecteur N et N1 et que l'interface entre la couche N1 et le substrat $N^+$ ne joue pratiquement plus de rôle dans les phénomènes physiques se produisant lors de la commutation à l'ouverture du transistor.

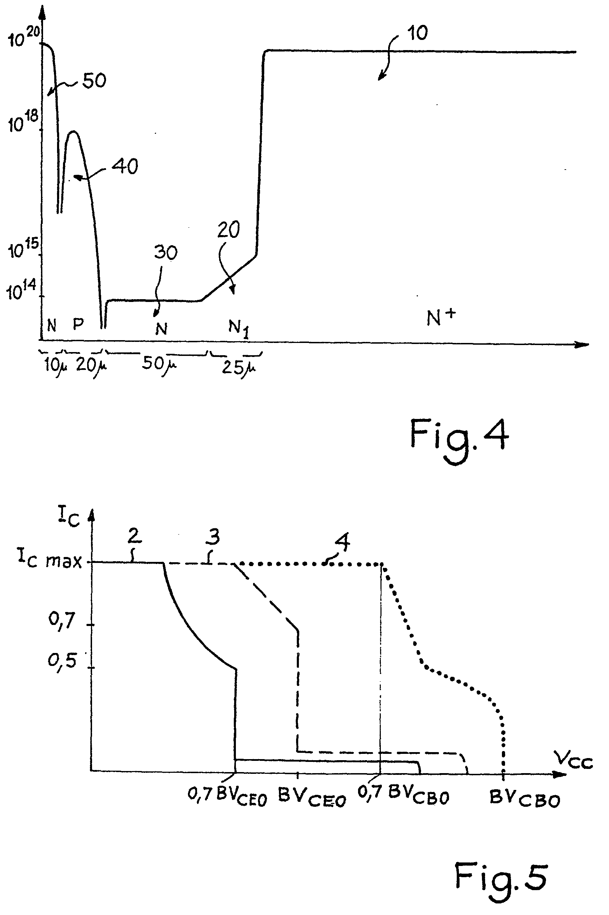

Comme on le verra ci-après, plus particulièrement en relation avec la figure 5, la tenue en tension en commutation à l'ouverture d'un transistor de puissance épitaxié du type illustré en figure 2 et même du type illustré en figure 3 est relativement limitée.

Un objet de la présente invention est de prévoir un transistor de puissance à bonne tenue en commutation à l'ouverture pouvant être fabriqué sur des plaquettes de grande surface.

Pour atteindre cet objet, la présente invention prévoit un transistor de puissance à tenue en tension élevée à l'ouverture obtenue par les étapes consistant à: partir d'un substrat d'un premier type de conductivité à fort niveau de dopage; former par épitaxie une zone intermédiaire du premier type de conductivité; former par épitaxie une couche de collecteur du premier type de conductivité à faible niveau de dopage; former ensuite une couche de base du deuxième type de conductivité, puis une couche d'émetteur du premier type de conductivité. Selon l'invention, la zone intermédiaire présente sur son épaisseur un gradient de concentration sensiblement constant de 20 à 40 microns par décade de concentration, la concentration de cette zone intermédiaire étant égale à celle de la couche de collecteur au niveau de cette couche et croissant en direction du substrat, l'épaisseur de la zone intermédiaire étant telle que la concentration du dopant chute d'au moins environ une décade sur l'épaisseur de cette zone.

Selon un mode de réalisation de l'invention, la zone intermédiaire est obtenue en faisant décroître continuellement la concentration de dopant au cours de l'épitaxie.

Selon un autre mode de réalisation de l'invention, la zone intermédiaire est obtenue en procédant à des dépôts épitaxiés successifs de couches minces, la concentration du dopant étant réduite pour chaque nouvelle couche et un lissage du gradient de concentration étant obtenu au cours des recuits ultérieurs.

Ces objets, caractéristiques et avantages ainsi que d'autres de la présente invention seront exposés dans la description suivante de modes de réalisation particuliers faite en relation avec les figures jointes parmi lesquelles:

— les figures 1 à 3 décrites précédemment illustrent des structures de transistor de puissance de l'art antérieur;

— la figure 4 illustre une structure de transistor de puissance selon la présente invention; et

— la figure 5 représente une courbe courant/tension pour des structures selon la présente invention comparativement à des structures selon l'art antérieur.

La figure 4 représente une structure de transistor de puissance selon la présente invention. Ce transistor comprend un substrat 10 de type $N^+$ suivi d'une zone 20 de même type de conductivité dont la concentration varie sensiblement continuement sur environ une décade de concentration (de $10^{15}$ à $10^{14}$ atomes/cm$^3$ dans l'exemple représenté) pour atteindre la concentration de la couche épitaxiée de collecteur 30 ($10^{14}$ atomes/cm$^3$

dans le cas illustré). Ce transistor comprend en outre de façon classique une zone de base 40 de type P formée par diffusion, puis une zone d'émetteur 50 de type N également formée par diffusion.

Le gradient de concentration de la zone intermédiaire 20 est choisi pour être d'une décade pour 20 à 40 microns d'épaisseur (en d'autres termes une demi à une décade par 20 microns d'épaisseur).

Pour obtenir cette zone intermédiaire 20 à gradient de concentration, on peut procéder à une épitaxie à partir du substrat 10 en faisant varier continuement la concentration de dopant selon une règle déterminée pour atteindre le gradient choisi ou bien réaliser des couches épitaxiées successives de faible épaisseur avec des concentrations en dopant décroissantes pour chacune des couches successives. Dans ce dernier cas, on obtient initialement une structure en marches d'escalier et cette structure en marches d'escalier se trouve fortement lissée lors des opérations de recuit ultérieures, notamment lors des opérations thermiques nécessaires pour effectuer les diffusions de base et d'émetteur. Par exemple, on pourra former successivement cinq couches d'une épaisseur de 5 à 7 microns ayant respectivement des concentrations de $10^{15}$ atomes/cm$^3$, $8.10^{14}$ atomes/cm$^3$, $6.10^{14}$ atomes/cm$^3$, $4.10^{14}$ atomes/cm$^3$ et $2.10^{14}$ atomes/cm$^3$; la redistribution naturelle lors des diffusions fera ensuite pratiquement disparaître les marches d'escalier.

Avant d'examiner plus en détail les avantages d'un transistor selon la présente invention, on va rappeler certaines notations habituellement utilisées pour définir les paramètres d'un transistor.

Ainsi, on désigne par:

— $I_C$ le courant de collecteur circulant dans un transistor quand il est à l'état de conduction,

— $V_{cc}$ la tension appliquée aux bornes du circuit dans lequel se trouve inséré le transistor; quand le transistor est bloqué, cette tension $V_{cc}$ se retrouve appliquée à ses bornes,

— $BV_{CEO}$ la tension de claquage collecteur/émetteur en base ouverte d'un transistor,

— $BV_{CBO}$ la tension de claquage collecteur/base d'un transistor, $BV_{CBO}$ est généralement sensiblement égal au double de $BV_{CEO}$,

— aire de sécurité une courbe indiquant le courant $I_C$ en fonction de la tension $V_{cc}$ et indiquant les valeurs à ne pas dépasser pour chaque couple $I_C/V_{cc}$ lors d'une commutation à l'ouverture pour ne pas dégrader le transistor.

Ainsi, alors qu'on a parlé jusqu'à présent de tenue en tension à l'ouverture, cette appellation n'a effectivement de sens que pour une valeur donnée du courant $I_C$ dans le transistor juste avant le blocage.

On va comparer les aires de sécurité de transistors épitaxiés des types illustrés en figures 2 et 3 et du type selon la présente invention illustré en figure 4, ces transistors étant tous dimensionnés pour présenter sensiblement la même valeur de courant maximum de collecteur $I_{Cmax}$ et les mêmes valeurs de tension de claquage $BV_{CEO}$ et $BV_{CBO}$.

Pour un transistor de type illustré en figure 2, l'aire de sécurité a sensiblement l'allure de la courbe 2 en trait plein de la figure 5. En pratique, la tension maximale que peut supporter ce transistor dès que le courant de collecteur a une valeur non négligeable mais non supérieure à environ 0,5 $I_{Cmax}$ est de l'ordre de 70% de $BV_{CEO}$; mais cette tension chute, comme l'indique la portion arrondie de la courbe, quand le courant se rapproche du courant maximal $I_{Cmax}$ qui ne peut être supporté que pour des tensions inférieures à environ 50% de $BV_{CEO}$. On notera une possibilité de supporter des tensions plus élevées, proches de $BV_{CBO}$ quand le courant de collecteur est très faible, mais ceci présente peu d'intérêt pratique.

Avec un transistor du type de celui de la figure 3, on trouve une aire de sécurité telle que celle représentée en tiretés par la courbe 3 de la figure 5. Cette courbe, sensiblement de même allure que la courbe 2, présente toutefois l'avantage que le transistor peut supporter à la commutation une tension $V_{cc}$ égale à $BV_{CEO}$ pour des valeurs de courant qui avoisinent environ 70% de la valeur $I_{Cmax}$. Egalement, dans le cas de la courbe 3, on relève une faible extension vers la droite de la courbe, c'est-à-dire que le transistor ne peut supporter des tensions proches de $BV_{CBO}$ que pour des courants de collecteur très faibles devant le courant $I_{Cmax}$.

Par contre, l'aire de sécurité se modifie notablement dans le cas d'un transistor selon la présente invention, comme cela est représenté par la courbe 4 en pointillés de la figure 5. Alors, la valeur $BV_{CEO}$ ne constitue pas une limitation particulière de l'aire de sécurité. Au contraire, le transistor peut supporter une tension proche de $BV_{CBO}$ lors de commutations à l'ouverture se produisant alors que le courant de collecteur avant la commutation est important. De plus, le transistor peut supporter des tensions de l'ordre de 70% de $BV_{CBO}$ alors que le courant avant la commutation était égal à $I_{Cmax}$.

En fait, cette amélioration de l'aire de sécurité obtenue avec des transistors selon la présente invention est d'une grande importance car on considérait dans la pratique que l'aire de sécurité était limitée en tension pour des transistors épitaxiés à une valeur proche de $BV_{CEO}$ et cette règle empirique était devenue une espèce de limitation théorique dans l'esprit de nombreux fabricants. Contrairement à cette idée reçue, la présente invention montre qu'on peut obtenir un transistor épitaxié dont l'aire de sécurité est limitée par la tension $BV_{CBO}$ qui a une valeur sensiblement double pour un transistor donné de celle de $BV_{CEO}$.

A titre d'exemple numérique, un transistor selon la présente invention peut être réalisé à partir de plaquettes d'une épaisseur de 500 microns d'une résistivité de 8 à $10.10^{-3}$ ohms-cm ($10^{19}$ atomes/cm$^3$). Pour un $BV_{CBO}$ de 1000 volts, on choisira une largeur de collecteur de 30 à 40 microns avec une résistivité de 30 à 55 ohms-cm (1 à $2.10^{14}$ atomes/cm$^3$) et une zone intermédiaire d'une largeur de 20 microns sur laquelle la concentration en impuretés varie d'environ 0.8 décade (de 1 à $2.10^{14}$ jusqu'à 8 à $15.10^{14}$ respectivement). Pour un $BV_{CBO}$ de 1500 volts, la largeur de la zone de collecteur sera de 70 à 90 microns avec une résistivité de 60 à 75 ohms-cm (une concentration de 6 à $8.10^{13}$ atomes/cm$^3$) et la largeur de la zone intermédiaire sera de l'ordre de 30 microns sur laquelle la concentration variera d'une décade (de 6 à $8.10^{13}$ jusqu'à 6 à $8.10^{14}$ respectivement). Dans le premier cas ($BV_{CBO}$ = 1000 volts), la largeur totale des zones de base et d'émetteur sera de 15 microns et, dans le deuxième cas ($BV_{CBO}$ = volts), la largeur d'ensemble des zones de base et d'émetteur sera de l'ordre de 25 microns. Dans les deux cas, la tenue en tension du dispositif sera de l'ordre de $BV_{CBO}$ (respectivement 1000 et 1500 volts) et non de $BV_{CEO}$ (c'est-à-dire respectivement 500 et 750 volts).

## Revendications

1. Transistor de puissance à tenue en tension élevée à l'ouverture obtenu par les étapes consistant à: partir d'un substrat (10) d'un premier type de conductivité à fort niveau de dopage; former par épitaxie une zone intermédiaire (20) du premier type de conductivité; former par épitaxie une couche de collecteur (30) du premier type de conductivité à faible niveau de dopage; former ensuite une couche de base (40) du deuxième type de conductivité, puis une couche d'émetteur (50) du premier type de conductivité, caractérisé en ce que la zone intermédiaire (20) présente sur son épaisseur un gradient de concentration sensiblement constant de 20 à 40 µm par décade de concentration, la concentration de cette zone intermédiaire étant égale à celle de la couche de collecteur au niveau de cette couche et croissant en direction du substrat, l'épaisseur de la zone intermédiaire étant telle que la concentration du dopant chute d'au moins environ une décade sur l'épaisseur de cette zone.

2. Transistor selon la revendication 1, caractérisé en ce que la zone intermédiaire est obtenue en faisant décroître continuement la concentration de dopant au cours de l'épitaxie.

3. Transistor selon la revendication 1, caractérisé en ce que la zone intermédiaire est obtenue en procédant à des dépôts épitaxiés successifs de couches minces, la concentration du dopant étant réduite pour chaque nouvelle couche et un lissage du gradient de concentration étant obtenu au cours de recuits ultérieurs.

4. Transistor selon l'une quelconque des revendications 1 à 3, caractérisé en ce que les zones de base et d'émetteur sont formées par diffusion.

## Claims

1. A power transistor with open circuit voltage holding properties obtained by the stages consisting of: starting with a substrate (10) with a first kind of conductivity having a high dopage level; epitaxially forming an intermediate zone (20) with the first kind of conductivity; by epitaxially forming a collector layer (30) with the first kind of conductivity and a low dopage level; then forming a base layer (40) with the second kind of conductivity, then an emitter layer (50) with the first kind of conductivity, characterized in that the intermediate zone (20) has a substantially constant concentration gradient in its thickness equal to 20 to 40 μm per ten-fold concentration difference, the concentration of this intermediate zone being equal to that of the collector layer at the level of this layer and increasing towards the substrate, the thickness of the intermediate zone being such that the concentration of doping agent decreases by about at least a factor of ten across the thickness of this zone.

2. A transistor according to Claim 1, characterized in that the intermediate zone is obtained by continuously decreasing the concentration of doping agent during the epitaxial formation.

3. A transistor according to Claim 1, characterized in that the intermediate zone is obtained by making successive epitaxial depositions of thin layers, the concentration of doping agent being decreased with each new layer and a smoothing of the concentration gradient being obtained during subsequent annealing steps.

4. A transistor according to any one of Claims 1 to 3, characterized in that the base and emitter zones are formed by diffusion.

**Patentansprüche**

1. Leistungstransistor, welcher gegen hohe Spannungen beim Öffnen resistent ist und durch folgende Schritte erhalten wird:
Ausgehen von einem Substrat (10) einer ersten Art spezifischer elektrischer Leitfähigkeit mit hohem Dotierungsniveau; mittels Epitaxie Bilden einer Zwischenzone (20) der ersten Art spezifischer elektrischer Leitfähigkeit; durch Epitaxie Bilden einer Kollektorschicht (30) der ersten Art spezifischer elektrischer Leitfähigkeit mit niedrigem Dotierungsniveau; darauffolgendes Bilden einer Basisschicht (40) der zweiten Art spezifischer elektrischer Leitfähigkeit, dann einer Emitterschicht (50) der ersten Art spezifischer elektrischer Leitfähigkeit,
dadurch gekennzeichnet, dass die Zwischenzone (20) über ihre Dickenabmessung einen im wesentlichen konstanten Konzentrationsgradienten von 20 bis 40 μm über eine Konzentrationsdekade aufweist, dass die Konzentration dieser Zwischenzone gleich der der Kollektorschicht ist beim Niveau dieser Schicht und ansteigend in Richtung des Substrats, und dass die Dickenabmessung der Zwischenzone so ist, dass die Dotierstoffkonzentration um zumindest etwa eine Dekade über die Dicke dieser Zone fällt.

2. Transistor nach Anspruch 1,
dadurch gekennzeichnet, dass die Zwischenzone dadurch erhalten wird, dass für ein kontinuierliches Abnehmen der Dotierstoffkonzentration während der Epitaxie gesorgt wird.

3. Transistor nach Anspruch 1,
dadurch gekennzeichnet, dass die Zwischenzone dadurch erhalten wird, dass die aufeinanderfolgenden Epitaxie-Ablagerungen in dünnen Schichten vorgenommen werden, wobei die Dotierstoffkonzentration für jede neue Schicht reduziert wird und eine Glättung des Konzentrationsgradienten während eines späteren Ausglühens erhalten wird.

4. Transistor nach einem der Ansprüche 1 bis 3, dadurch gekennzeichnet, dass die Basis- und Emitterzonen durch Diffusion gebildet sind.

Fig.1

Fig.2

Fig.3

Fig.4

Fig.5